# EUROPEAN PATENT SPECIFICATION

(11) **EP 0 624 881 B1**
(45) Date of publication and mention of the grant of the patent: **15.09.1999**
(21) Application number: 93309727.1
(22) Date of filing: 03.12.1993
(51) Int. Cl.: G11C 19/28

(54) **Improvements in or relating to serial registers**
Verbesserungen an Schieberegistern
Améliorations à des registres à décaloge

(30) Priority: 04.12.1992 JP 35076192
(43) Date of publication of application: 17.11.1994
(73) Proprietor: TEXAS INSTRUMENTS INCORPORATED, Dallas Texas 75265 (US)
(72) Inventor: Takahashi, Hiroshi, 3-6-12, Kita-Aoyama, Minato-ku (JP)
(74) Representative: Legg, Cyrus James Grahame

(56) References cited:
- EP-A- 0 237 337
- TECHNICAL DIGEST - WESTERN ELECTRIC. ANNEE 1968/1975: 2EME EXEMPLAIRE B-00-120, no.74, July 1984, NEW YORK US page 5 BARTOLI 'Dynamic MOS Shift Register Stage'

## Description

The present invention pertains to serial registers, for example a shift register constituted by using MIS (Metal Insulation Semiconductor) transistors.

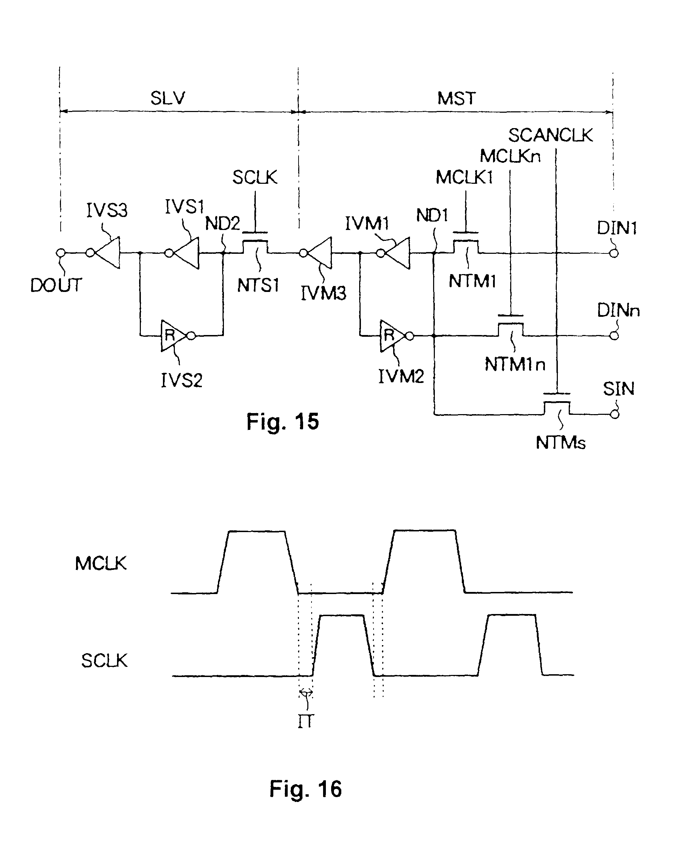

Figure 15 is a circuit diagram showing the basic configuration of a conventional shift register operable with power voltage Vₚₚ=5.0V.

In Figure 15, MST is the master latch, SLV is the slave latch, NTM1, NTM1n, NTMs, and NTS1 are transfer gates composed of n-channel MOS transistors with threshold value voltage V_{thN} of about 1V, IVM1, IVM2, IVM3, IVS1, IVS2 and IVS3 are inverters, DIN1, DINn, and SIN are data input terminals, and DOUT is the data output terminal.

Master latch MST is comprised of transfer gates NTM1, NTM1n, NTMs, and inverters IVM1, IVM2, IVM3.

Specific connections are that each input terminal of transfer gates NTM1, NTM1n, and NTMs is connected respectively to data input terminals DIN1, DINn, and SIN, and each output terminal of transfer gates NTM1, NTM1n, and NTMs is connected to the input terminal of inverter IVM1 and output terminal of inverter IVM2.

Also, the output terminal of inverter IVM1 is connected to the input terminals of inverters IVM2 and IVM3, and the output terminal of inverter IVM2 is connected to the input terminal of inverter IVM1.

Namely, inverters IVM1 and IVM2 are connected between the input terminal of inverter IVM3 and output terminal of each transfer gates NTM1, NTM1n, and NTMs in parallel with the input/output terminals in the opposite orientation.

Inverter IVM2 is constituted with a high-resistance type inverter for safe operation of the circuit and prevention of through current.

Slave latch SLV is comprised of transfer gate NTS1 and inverters IVS1, IVS2, and IVS3.

The specific connections are that the input terminal of transfer gate NTS1 is connected to the output terminal of inverter IVM3 in master latch MST, and the output terminal is connected to the input terminal of inverter IVS1 and output terminal of inverter IVS2.

Also, the output terminal of inverter IVS1 is connected to the input terminals of inverters IVS2 and IVS3, and the output terminal of inverter IVS2 is connected to the input terminal of inverter IVS1.

Namely, inverters IVS1 and IVS2 are connected between the input terminal of inverter IVS3 and the output terminal of transfer gate NTS1 in parallel with the input/output terminals in the opposite orientation.

Inverter IVS2 is comprised of a high-resistance inverter for safe operation of the circuit and prevention of through current.

Also, each gate terminal of each transfer gate NTM1, NTM1n, NTMs and NTS1 is connected respectively to the control system through the signal line, not shown in the figure, and prescribed level in which the timing is controlled by said control system, for example, clock signals of 5 V are input.

specifically, clock signal MCLK1 is input into the gate terminal of transfer gate NTM1, and clock signal MCLKn is input into the gate terminal of transfer gate NTM1n. Said first clock signals (1,n) do not become high level at the same time.

Also, scan clock signal SCANCLK for device test is input into the gate terminal of transfer gate NTMs.

On the other hand, clock signal SCLK in which the phase differs from clock signal MCLK (1,n) is input into the gate terminal of transfer gate NTS1.

Figure 16 is the timing chart showing the relationship between clock signal MCLK 1,n and clock signal SCLK.

As shown in Figure 16, clock signal MCLK and clock signal SCLK are out of phase by 180°, and so-called isolation time IT is provided in which both signals become low level in order to prevent clock skew.

Therefore, input of the clock signals is controlled so that when transfer gate NTM1 or NTM1n of master latch MST is in the ON state, transfer gate NTS1 of slave latch SLV maintains the OFF state, and when transfer gate NTS1 of slave latch SLV is in the ON state, transfer gate NTM1 or NTMn of master latch MST maintains the OFF state.

Transfer gate NTMs for scanning is provided for testing of the device and scan clock SCANCLK input into the gate terminal of said transfer gate NTMs is input with the same timing as clock signal MCLK.

Namely, the input of the clock signals is controlled during the device test so that when transfer gate NTMs for scanning is in the ON state, transfer gate NTS1 of slave latch SLV maintains the OFF state, and when transfer gate NTS1 of slave latch SLV is in the ON state, transfer gate NTMs for scanning maintains the OFF state.

Here, the operation of a case when data in high level "1" of 5 V is input into input terminal DIN1 will be explained in the constitution of Figure 15.

When data at high level "1" of 5 V is input into input terminal DIN1, transfer gate NTM1 takes on the ON state if clock signal MCLK1 is input into the gate terminal of transfer gate NTM1 at high level of 5 V.

By it, the input data of high level 5 V passes through transfer gate NTM1 but at this time, level at output terminal side node ND1 of transfer gate NTM1 becomes about 3.5 V due to the substrate effect and threshold value voltage V_{thN} (about 1 V) of transfer gate NTM1, and this level is applied to the input terminal of inverter IVM1.

The circuit threshold value of inverter IVM1 is generally set at about 1/2 of power voltage V_{DD} or a level slightly lower than that so the output side becomes a low level due to the level inversion function of inverter IVM1. At this time, the input level is 3.5 V which is lower than 5 V so some through current flows.

Low level which is the output of inverter IVM1 is applied to the input terminal of inverter IVM2 and inverter IVM3.

Inverter IVM2 is constituted with a high-resistance type inverter as it was noted above, the output which received low level becomes about 5 V, and high level if 5 V is applied to the input terminal of inverter IVM1.

Namely, the data level which decreased to about 3.5 V due to the substrate effect or threshold voltage V_{thN} of transfer gate NTM1 is compensated and flow of through current is suppressed; thus, the high level is stably maintained.

Next, clock signal MCLK1 becomes low level and when clock signal SCLK is input into gate terminal of transfer gate NTS1 in slave latch SLV at high level, transfer gate NTM1 takes on the OFF state and transfer gate NTS1 takes on the ON state.

By it, high level output of inverter IVM3 in master latch MST passes through transfer gate NTS1 but at this time, as in the case of master latch MST, the level in output terminal side node ND2 of transfer gate NTS1 becomes about 3.5 V due to the substrate effect and threshold voltage V_{thN} of transfer gate NTS1, and this level is applied to the input terminal of inverter IVS1.

The circuit threshold value of inverter IVS1 is set at about 1.2 of power voltage V_{DD} or a level slightly lower than that, as noted above, so the output side becomes low level due to the level inversion function of inverter IVS1. At this time, the input level is 3.5 V which is lower than 5 V so some through current flows.

Low level which is output of inverter IVS1 is applied to the input terminal of inverter IVS3 and inverter IVS2.

Inverter IVS2 is constituted with a high-resistance type inverter, as noted above, the output which received low level becomes about 5 V, and this high level of 5 V is applied to the input terminal of inverter IVS1.

Namely, the data level which dropped to about 3.5 V due to the substrate effect and threshold value voltage V_{thN} of transfer gate NTS1 is compensated, and the flow of through current is suppressed; thus, the level is stably maintained.

Thus, a stabilized high-level output is obtained from inverter IVS3 and output from data output terminal DOUT.

As noted above, the circuit in Figure 15 is stably operated as a shift register which shifts the data successively with clock signal MCLK and clock signal SCLK under power voltage V_{DD} of 5 V.

### Problems the invention aims to solve

However, from the need to reduce power consumption in recent years and to secure reliability in fine ICs, the bottom limit for power voltage V_{DD} of 3.0 V or 2.7 V and depending on the application, a need to secure operation at even lower voltage is being created.

When power voltage V_{DD} is decreased, not only is a considerable decrease in the operational speed of the IC created, but, in circuits of shift register, etc., there was the problem of sufficient propagation of a high level not being possible due to said substrate effect or threshold value voltage V_{thN} of the transistor itself when propagating high level in n-channel transfer gates thus the operation became defective.

The level, after propagating through the transfer gate, becomes approximately (V_{DD} - V_{thN}) and under low power voltage, the propagated level becomes lower than the decrease in power voltage V_{DD}.

The circuit threshold value with inverter receiving this level is set to about 1/2 of power voltage V_{DD} or a level slightly lower than that under realistic beta ratio in the design so in order to transmit sufficient level over said circuit threshold value to the node after propagating through the transfer gate, it is necessary to decrease the threshold value voltage V_{thN} or raise the gate voltage.

In order to solve this problem, a proposal for changing to a process of lowering the threshold value voltage V_{thN} by decreasing, for example, the p-type concentration of n-type channel during the manufacturing process is being presently proposed.

However, the gate length of the transistor in VLSI has reached the area of submicrons in recent years, and sufficient punchthrough pressure resistance cannot be secured when threshold value voltage V_{thN} is decreased too much. Also, even when the transistor is in the OFF state, it is necessary to solve various problems during the mass production such as the so-called subthreshold current due to the short channel effect in which the current flows due to widening of the depletion layer from the drain, etc.

Also, improving the control of loss in the yield created by the above is also a load in the process and even if threshold value voltage V_{thX(-N, P)} is decreased to a realistic value, the situation will become difficult requiring that consideration also be given to the margin with respect to the variance in the manufacture in order to secure power voltage V_{DD} = 2.7 V in said circuits.

Furthermore, when shrinkage of 65 µm/0.5 µm, etc., are also included in the consideration, the situation becomes even more difficult in the future.

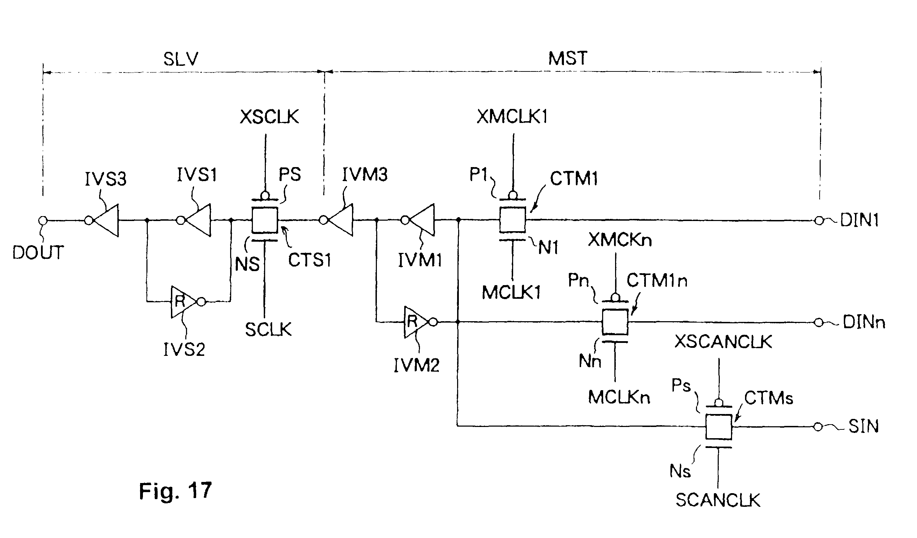

Therefore, with respect to the operational need for power voltage V_{DD} = less than 2.7 V, a so-called complete CMOS type shift register is generally known conventionally with a constitution which replaced all n-channel transfer gates NTM1, NTM1n, NTMs, and NTS1 in Figure 15 with transfer gates CTM1, CTM1n, CTMs, and CTS1 composed of complementary type MOS (CMOS: complementary MOS) in which a decrease in power consumption and enhancement of the speed are possible like that which is shown in Figure 17.

In this complete CMOS type shift register, along with inputting clock signals MCLK1, MCLKn, and SCANCLK to each gate terminal of N-MOS transistors N1, Nn, and Ns constituting each CMOS transfer gate CTM1, CTM1n, and CTMs of master latch MST, by inputting inverted clock signals XMCLK1, XMCLKn, and XSCANCLK which inverted clock signals MCLK1, MCLKn, and SCANCLK to each gate terminal of P-MOS transistors P1, Pn, and Ps which constitute each CMOS transfer gate CTM1, CTM1n, and CTMs, each transfer gate CTM1, CTM1n, and CTMs are turned ON/OFF.

Similarly, along with inputting clock signal SCLK to the gate terminal of N-MOS-transistor NS constituting CMOS transfer gate CTS1 of slave latch SLV, by inputting inverted clock signal XSCLK which inverted clock signal SCLK into the gate terminal of P-MOS transistor PS constituting CMOS transfer gate CTS1, transfer gate CTS1 is turned ON/OFF.

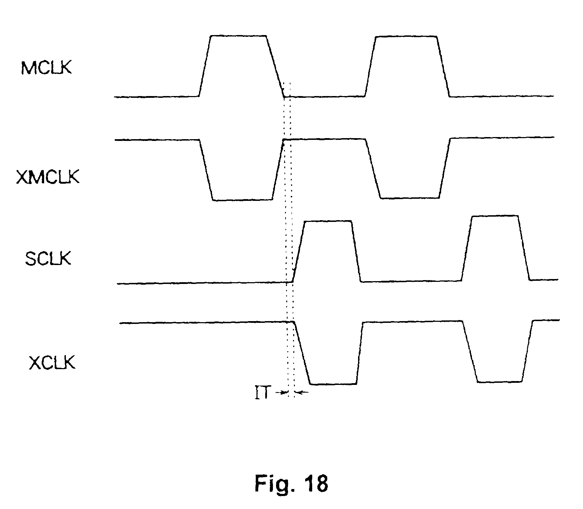

Also, Figure 18 shows the timing relationship of clock signal MCLK and inverted clock signal XMCLK, the timing relationship of clock signal SCLK and inverted clock signal XSCLK, and the timing relationship between the mutual clock signals.

As shown in Figure 18, the phase of clock signal MCLK and clock signal SCLK or inverted clock signal XMCLK and inverted clock signal XSCLK is displaced by 180°, and moreover, a so-called isolation time IT in which both signals become low level is provided in order to prevent clock skew.

The complete CMOS type shift register with this type of constitution operates stably as a shift register which shifts the data successively with clock signal MCLK and clock signal SCLK even under power voltage V_{DD} = 2.7 V.

However, a complete CMOS type shift register needs to provide clock signals to N-MOS transistors N1, Nn, Ns, and NS and P-MOS transistors N1, Nn, Ns, and NS which constitute each CMOS transfer gate CTM1, CTM1n, CTMs, and CTS1, and when the input of data increases, a clock count of double the number becomes necessary.

As a result, securing a fixed spacing with respect to the respective transistor and separation with wells become necessary caused by the increase in the layout area due to the wiring and the polarity of the p-channel and n-channel transfer gates being different.

Also, increase in the timing circuit for preventing clock skew or caution with respect to the clock skew of the p-channel and n-channel with enhancement in the speed of the IC becomes unavoidable and causes an increase in area. Also, buffer for p-channel drive also becomes necessary so it leads to an increase in the layout area. In the data bus, etc., the circuit scale of the clock driver increases since arithmetic is executed by selecting from a number of data inputs and, in this type of circuit state, a considerable increase in the layout area is generated.

EP-A 0 237 337, on which the preamble of claim 1 is based, shows a shift register with interconnected master latches and slave latches, each comprising cross-coupled inverters. Data is written into a master latch by providing both true and inverted data to the latch.

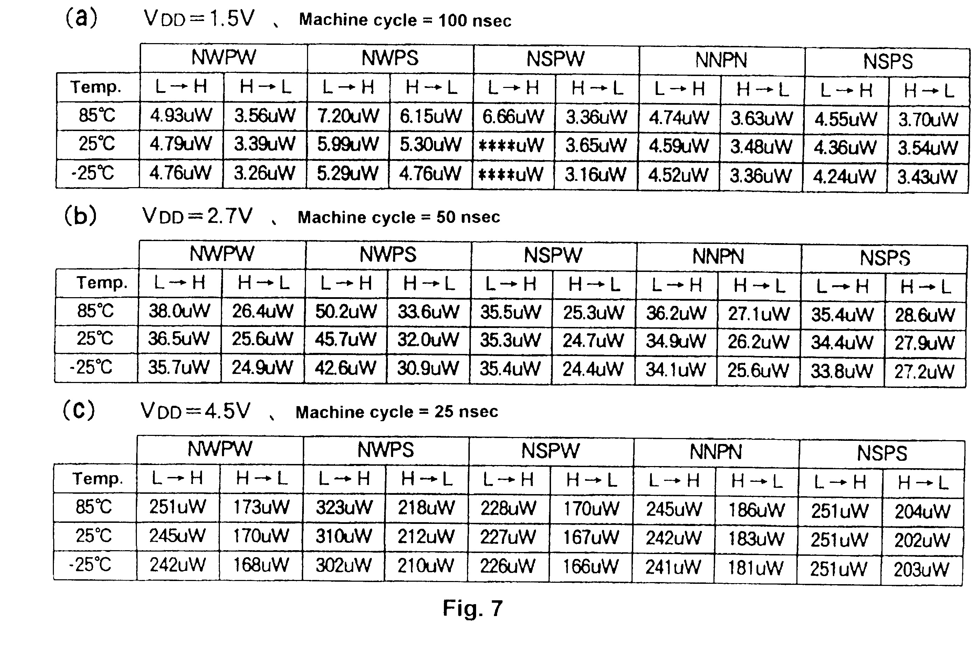

IEEE Journal of Solid-State Circuits, Vol. 25 No. 1 (February 1990) pages 142-149 discloses at Fig. 7b a flip-flop comprising two cross-coupled inverters. The input of one inverter is connected to a data input via a transfer gate controlled by a clock signal; the input of the other inverter is connected to ground via two transfer gates, one controlled by the clock signal and the other controlled by the data input.

The present invention aims to provide a shift register which can be operated stably not only under normal power voltage but even under low power voltage without making the circuit complex or increasing the layout area.

The invention provides a shift register for operation at a low supply voltage, comprising: a master stage with a first inverter and a second inverter connected in a cross-coupled manner; and a slave stage with a third inverter and a fourth inverter connected in a cross-coupled manner; input circuitry for coupling an input signal on a data input terminal to an input of the first inverter of the master stage and for coupling a second signal to an input of the second inverter in response to a first clock signal; coupling circuitry for coupling an output of the master stage to an input of the slave stage in response to a second clock signal; and a data output terminal connected to an output of the slave stage; characterised in that: the input circuitry includes a first transfer gate connected between the data input terminal and the input of the first inverter; and a second transfer gate and a third transfer gate connected in series between the input of the second inverter and a reference voltage terminal, such that the input of the second inverter is connected to the reference voltage terminal in response to the first clock signal and the input signal on the data input terminal; and the coupling circuitry includes a fourth transfer gate connected between an output of the second inverter and an input of the third inverter; and a fifth transfer gate connected between an output of the first inverter and an input of the fourth inverter.

### Function

The function of said invention will be explained on the premise that according to said invention, first, second, third, fourth, and fifth transfer gates are all n-channel MOS transistors.

When the first clock signal becomes a high level, the first transfer gate and one of either the third or second transfer gate take on the ON state, and input data of high level "1" or low level "0" input into the input terminal passes through the first transfer gate.

If the input data is high level, the signal level on the input side of the first inverter receives the level decreasing function of the substrate effect and threshold value voltage V_{thN} of the first transfer gate and becomes lower than the signal level in the input terminal. The threshold value voltage of the inverter is generally set at about 1/2 of power voltage V_{DD} or a value slightly lower than that so if the signal level on the input side of the first inverter is lower than the threshold value voltage of the first inverter, the first inverter cannot logically invert completely and the output of the first inverter becomes unstable. If the output of the first inverter becomes unstable, the second inverter also cannot logically invert completely, and the output of the second inverter also becomes unstable. If so, the problems of not being able to maintain high-level signals and allowing through currents to flow to the first and second inverters are created.

However, in said invention, the second or third transfer gate with lower threshold value voltage than the inverter is in the ON state due to the input data of high level so the input side of the second inverter is connected to the ground through the second and third transfer gates and becomes a stabilized low level. By it, the second inverter and the first inverter become logically inverted completely, the output side of the first inverter becomes stabilized low level and the output side of the second inverter becomes stabilized high level. This logical state is maintained stably even if the first clock signal becomes low level and the first transfer gate and the third or second transfer gate take on the OFF state.

Next, when the second clock signal becomes high level in a state, for example, of the first signal with the same level (high level) as the output side of the second inverter being applied to the first node, and the second signal with the same level (low level) as the output side of the first inverter being applied to the second node, the fourth and fifth transfer gates take on the ON state. Then, input side of the third inverter becomes high level and the input side of the fourth inverter becomes low level. At this time, the input side of the third inverter becomes a level lower than the first node by receiving the level decreasing function of the substrate effect and threshold value voltage of the fourth transfer gate. If this level is a level lower than the threshold value voltage of the third inverter, the third inverter cannot logically invert completely and the output level becomes unstable.

However, low level which passes through the fifth transfer gate does not receive the level decreasing function of the substrate effect and the threshold value voltage of the fifth transfer gate so the input side of the fourth inverter becomes stabilized low level. By this stabilized low level, the fourth inverter and the third inverter are logically inverted completely, the output side of the third inverter becomes a stabilized low level and the output side of the fourth inverter becomes a stabilized high level. This logical state is maintained stably even if the second clock signal becomes low level and the fourth and the fifth transfer gates take on the OFF state.

By it, a stabilized output of high level or low level is obtained from the shift register.

If the input data is low level, the second or third transfer gate does not take on the ON state but the low level which passes through the first transfer gate is maintained with stability since the prescribed level decreasing function of the substrate effect and the threshold value voltage of the first transfer gate is not received, and appears as stabilized low level on the input side of the first inverter. Consequently, the first inverter and the second inverter logically invert completely and operate stably as a shift register.

As explained above, according to said invention, it is possible to realise a shift register which can be operated stably not only under normal power voltage but even under low power voltage without making the circuit complex or increasing the layout area.

### Brief description of the figures

Figure 1 is a circuit diagram showing the first application example of a shift register related to said invention.

Figure 2 is a table showing the operational speed on the master latch side when simulation is executed at power voltage Vpp=2.7V.

Figure 3 is a table showing the operational speed on the slave latch side when simulation is executed at power voltage Vpp=2.7V.

Figure 4 is a table showing the power consumption within a given transmission time when simulation is executed at power voltage Vpp=2.7V.

Figure 5 is a table showing the operational speed on the master latch side of said invention's product when simulation is executed by changing power voltage Vpp to 1.5V, 2.7V, and 4.5 V at temperatures 85°C, 25°C and -25°C.

Figure 6 is a table showing the operational speed on the slave latch side of said invention's product when simulation is executed by changing power voltage Vpp to 1.5V, 2.7V and 4.5 V at temperatures 85°C, 25°C and -25°C.

Figure 7 is a table showing the power consumption of said invention's product when simulation is executed by changing power voltage Vpp to 1.5V, 2.7V and 4.5V at temperatures 85°C, 25°C and -25°C.

Figure 8 is a circuit diagram showing the second application example of a shift register related to said invention.

Figure 9 is a table showing comparative examples of the area ratio and size between the conventional CMOS type circuit and said invention's products shown in Figures 1 and 8.

Figure 10 is a circuit diagram showing the third application example of a shift register related to said invention.

Figure 11 is a circuit diagram showing the fourth application example of a shift register related to said invention.

Figure 12 is a circuit diagram showing the fifth application example of a shift register related to said invention.

Figure 13 is a circuit diagram showing the sixth application example of a shift register related to said invention.

Figure 14 is a circuit diagram showing the seventh application example of a shift register related to said invention.

Figure 15 is a circuit diagram showing the basic constitution of a conventional shift register operable at power voltage Vpp=5.0V.

Figure 16 is a timing chart for explaining the first and second clock signals.

Figure 17 is a circuit diagram of a conventional complete CMOS type shift register.

Figure 18 is a timing chart for explaining the first and second clock signals and inverted first and inverted second clock signals.

Embodiments of the present invention will now be described by way of example only.

### Application Example 1

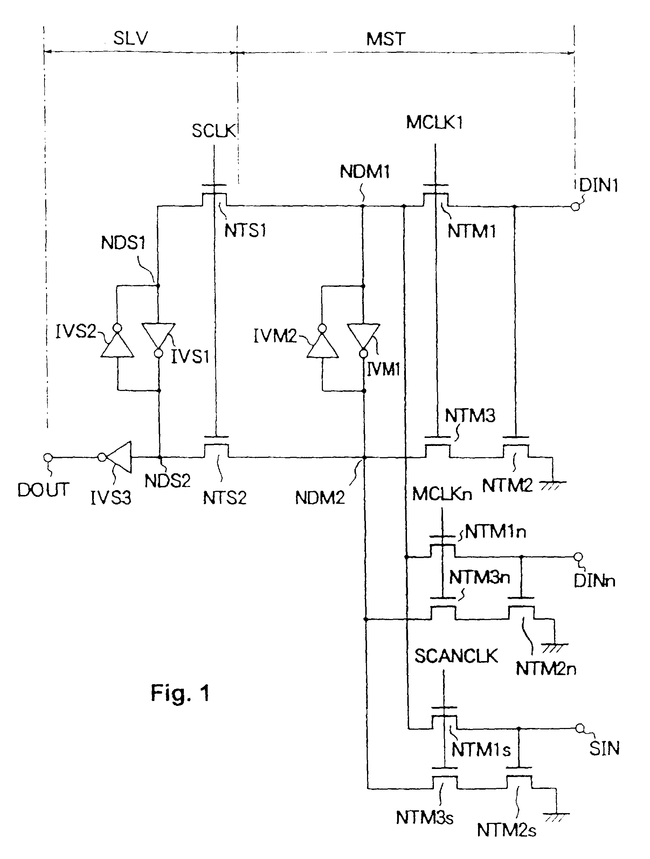

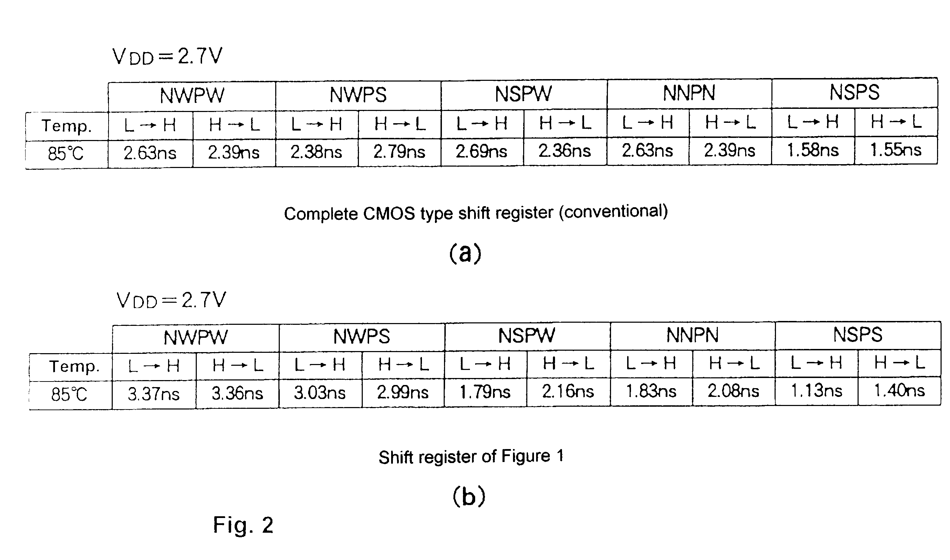

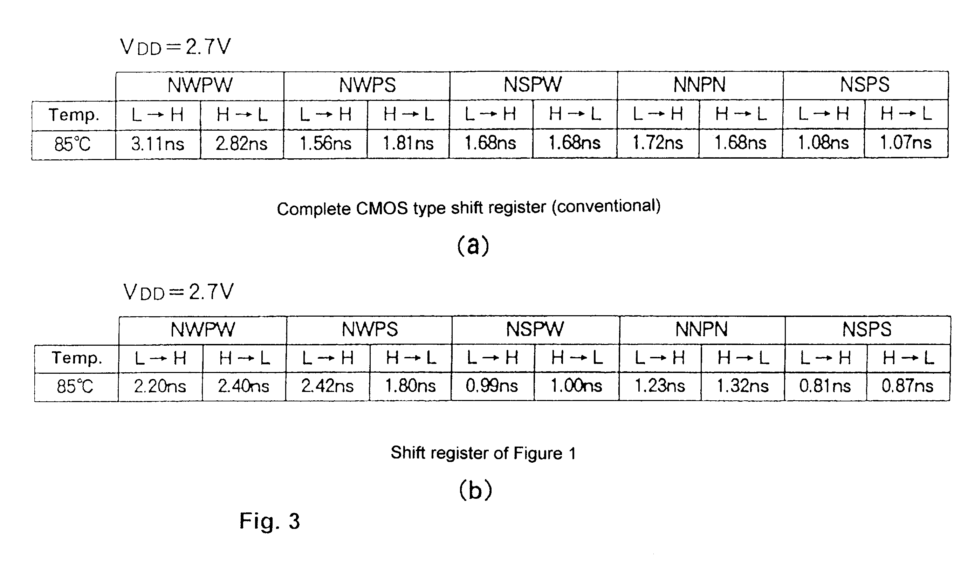

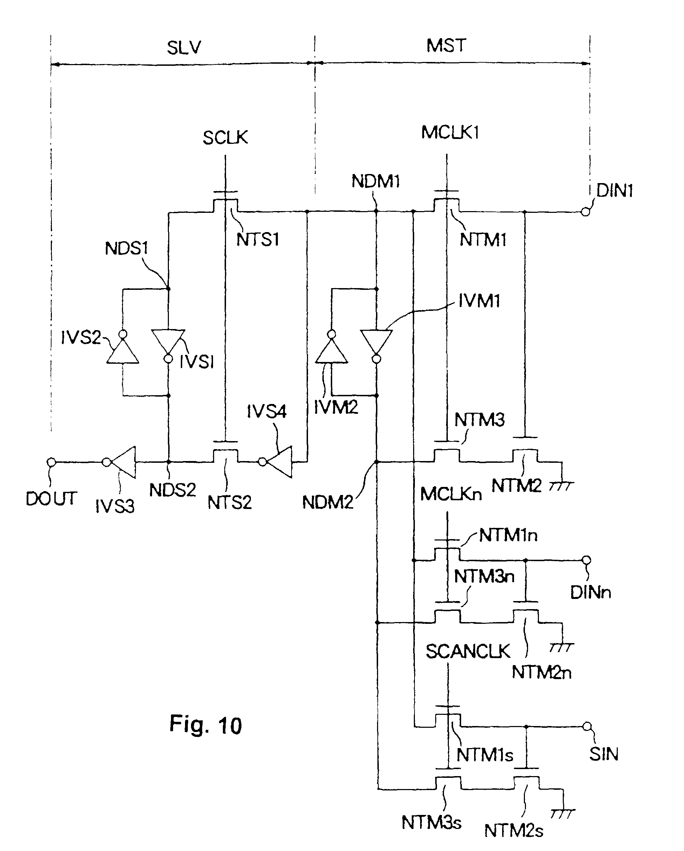

Figure 1 is a circuit diagram showing the first application example of a shift register related to said invention which was constituted using 3 n-channel transfer gates and inverters, and the same constitutional parts as Figure 10 showing a conventional example are expressed with the same codes.

Namely, MST is the master latch, SLV is the slave latch, NTM1, NTMn, NTM1s, NTM2, NTM2n, NTM2s, NTM3, NTM3n, NTM3s, NTS1 and NTS2 are transfer gates composed of n-channel MOS transistors with threshold value voltage V_{thN} of about 1V, IVM1, IVM2, IVS1, IVS2 and IVS3 are inverters, DIN1, DINn, and SIN are data input terminals, DOUT is the data output terminal, MCLK1 and MCLKn are clock signals, SCLK is the clock signal, and SCANCLK is the scan clock signal.

Master latch MST is comprised of transfer gates NTM1, NTM1n, NTM2, NTM3, NTM3n, NTM1s, NTM2s and NTM3s, and inverters IVM1 and IVM2.

Specific connections are that the input terminal of transfer gate NTM1 and gate terminal of transfer gare NTM2 are connected to data input terminal DIN1. The input terminal of transfer gate NTM2 is grounded, and the output terminal is connected to the input terminal of transfer gate NTM3.

Also, inverters IVM1 and IVM2 are connected in parallel by mutually opposing the orientation of the input/output terminals between the output terminal of transfer gate NTM3 and output terminal of transfer gate NTM1.

Inverter IVM2 differs from the conventional constitution in that it does not have to be a high-resistance inverter but when reduction in power consumption is considered, it is preferable to constitute with small transistors like SRAM.

similarly, the input terminal of transfer gate NTM1n and the gate terminal of transfer gate NTM2n are connected to data input terminal DINn. The input terminal of transfer gate NTM2n is grounded and the output terminal is connected to the input terminal of transfer gate NTM3n.

Also, inverters IVM1 and IVM2 are connected in parallel by mutually opposing the orientation of the input/output terminals between the output terminal of transfer gate NTM3n and the output terminal of transfer gate NTM1n.

Furthermore, the input terminal of transfer gate NTM1s and the gate terminal of transfer gate NTM2s are connected to data input terminal SIN. The input terminal of transfer gate NTM2s is grounded and the output terminal is connected to the input terminal of transfer gate NTM3s.

Also, inverters IVM1 and IVM2 are connected in parallel by mutually opposing the orientation of the input/output terminals between the output terminal of transfer gate NTM3s and the output terminal of transfer gate NTM1s.

Slave latch SLV is constituted of transfer gates NTS1 and NTS2 and inverters IVS1, IVS2, and IVS3.

Specific connections are that the input terminal of transfer gate NTS1 is connected to the output terminals of transfer gate NTM1, NTM1n, and NTM1s of master latch MST, and the input terminal of transfer gate NTS2 is connected to the output terminals of transfer gates NTM3, NTM3n, and NTM3s of master latch MST.

Also, inverters IVS1 and IVS2 are connected in parallel by mutually opposing the orientation of the input/output terminals between the output terminal of transfer gate NTS2 and the output terminal of transfer gate NTS1.

Furthermore, the input terminal of inverter IVS3 is connected at the connection point of the input terminal of inverter IVS2 and output terminal of inverter IVS1, and the output terminal of inverter IVS3 is connected to data output terminal DOUT.

Inverter IVS2 differs from the conventional constitution in that it is not necessary for the inverter to be the high-resistance type but when reduction in power consumption is considered as in the above, it is preferable to constitute with small transistors like SRAM.

Also, the gate terminals of transistors NTM1, NTM1n, NTM1s, NTM3, NTM3n, and NTM3s in master latch MST and the gate terminals of transfer gates NTS1 and NTS2 in slave latch SLV are connected to the control system through the respective signal lines not shown in the figures, and clock signals of prescribed level such as 5 V or lower of 2.7 V, 2 V, 1.7 V, etc., in which the timing is controlled by said control system are input.

Specifically, clock signal MCLK1 is input into the gate terminals of transfer gate NTM3 and the gate of transfer gate NTM1 in master latch MST.

Similarly, clock signal MCLKn is input into the gate terminal of transfer gate NTM3n and the gate terminal of transfer gate NTM1n.

Also, scan clock signal SCANCLK for device test is input into the gate terminal of transfer gate NTM3s and gate terminal of transfer gate NTM1s.

Furthermore, clock signals MCLK (1,n), scan clock signals SCANCLX, and clock signals SCLK in which the phase has been 180° dislocated are input into the gate terminal of transfer gate NTS2 and the gate terminal of transfer gate NTS1 in slave latch SLV.

Therefore, the input of the clock signals is controlled so that when transfer gates NTM1, NTM3, NTM1n, and NTM3n or NTM1s and NTM3n of master latch MST are in the ON state, transfer gates NTS1 and NTS2 of slave latch SLV maintain the OFF state, and when transfer gate NTS1 and NTS2 of slave latch SLV are in the ON state, transfer gates NTN1, NTM3, NTM1n, and NTM3n or NTM1s and NTM3s of master latch MST maintain the OFF state.

Next, the operation based on said constitution will be explained by taking a case when data of high level "1" is input at, for example, 2 V in input terminal DIN1 as an example.

High level "1" data of 2 V input to input terminal DIN1 is input into the gate terminal of transfer gate NTM2 and the input terminal of transfer gate NTM1, and transfer gate NTM2 takes on the ON state.

At this time, when clock signals MCLK1 are input respectively into the gate terminal of transfer gate NTM3 and the gate terminal of transfer gate NTM1 at high level of 2 V, transfer gates NTM1 and NTM3 take on the ON state.

By it, the input data of high level 2 V passes through transfer gate NTM1 but at this time, the level in node NDM1 on the output terminal side of transfer gate NTM1 becomes about 1 V or lower due to the substrate effect or threshold value voltage V_{thN} (about 1 V) of transfer gate NTM1 and this level is applied to the input terminal of inverter IVM1.

The circuit threshold value of inverter IVM1 is generally set at about 1/2 of power voltage V_{DD} or a level slightly lower so at the beginning of the data input, node NDM2 on the output side becomes low level due to the level inversion function of inverter IVM1. Since the input level is lower than 2 V of 1 V or lower, some through current flows but this unstable low level is applied to the input terminal of inverter IVM2, and the output side inverter IVM2 is maintained more or less at a high level although node NDM1 is unstable.

However, at this time, transfer gates NTM2 and NTM3 are in the ON state as noted above so node NDM2 is made mandatorily into the ground level and gradually becomes stabilized low level of 0 V.

This stabilized low level is applied to the input terminal of inverter IVM2 and the output side of inverter IVM2, namely, node NDM1 is maintained at stabilized high level of about 2 V.

Namely, the data level which decreased to about 1 V due to the substrate effect and threshold value voltage V_{thN} of transfer gate NTM1 is compensated, and node NDM1 and node NDM2 are maintained stably at high level and low level respectively.

Next, clock signal MCLK1 becomes low level, clock signal SCLK is input into the gate terminals of transfer gates NTS1 and NTS2 in slave latch SLV at high level, transfer gates NTM1 and NTM3 take on the OFF state, and transfer gates NTS1 and NTS2 take on the ON state. By it, the high level of node NDM1 in master latch MST passes through transfer gate NTS1, and appears in node NDS1 by receiving the prescribed level decreasing function of the substrate effect and threshold value voltage V_{thN} of transfer gate NTS1 at this time, along with stabilized low level of node NDM2 passing through transfer gate NTS2 and appearing in node NDS2 without receiving the prescribed level decreasing function of the substrate effect and threshold value voltage V_{thN} of transfer gate NTS2 at this time.

Low level which appeared in node NDS2 of slave latch SLV is maintained stably since the prescribed level decreasing effect of the substrate effect and threshold value voltage V_{thN} of transfer gate NTS2 is not received. Consequently, node NDS1 also maintains stabilized high level.

Then, the stabilized low level of node NDS2 is applied to the input terminal of inverter IVS3 and, by it, a stabilized high level output is obtained from inverter IVS3, and output from data output terminal DOUT.

When the input data is a low level, transfer gate NTM2 of master latch MST does not take on the ON state, but a low level which passes through transfer gate NTM1 is maintained stably without receiving the prescribed level decreasing function of the substrate effect and threshold value voltage V_{thN} of transfer gate NTM1 and appears in node NDM1 thus node NDM2 on the output side of inverter IVM1 is also maintained in stabilized high level and operates stably as a shift register.

Transmission of data from master latch MST to slave latch SLV is executed by the level of node NDM1 and NDM2 established by inverters IVM1 and IVM2 passing through transfer gates NTS1 and NTS2. Elements which become causes for large loads such as the gate terminals of transistors are not connected to nodes NDM1 and NDM2 so inverters IVM1 and IVM2 which execute data transmission and establish the level of nodes NDM1 and NDM2 do not need that large a drive capacity. Therefore, it is possible to make the size of the transistors constituting inverters IVM1 and IVM2 small. This is effective for reducing the layout area of the shift register.

As noted above, the circuit in Figure 1 operates stably as a shift register which shifts the data successively with clock signals MCLK1 and clock signals SCLK under power voltage V_{DD} 2 V.

Also said shift register operates stably without any problems under 5 V which is the normal power voltage level.

As explained above, according to this application example, it is not necessary to decrease threshold value voltage V_{thN} of n-channel transfer gate which becomes a burden in the manufacturing process, and can realize shift registers which are operable at sufficiently low voltage with only single clock signal for n-channel.

Also, said shift register basically uses 3 n-channel transfer gates on the master latch MST side and the transistor count is increased by one with respect to 2 gates in the conventional complete CMOS type.

However, the slave latch SLV side uses two n-channel transfer gates so increase in the transistor count is small in the shift register as a whole.

Furthermore, all the transfer gates are constituted with n-channel transistors so separation layers such as wells or separation of the transistors is not necessary; thus, there is the advantage of being suited for enhancing the integration.

In addition, in the case of the conventional 1 transistor/n-channel transfer gate shown in Figure 10, the element count is small but in the layout, the periphery becomes the wiring area and there is nothing under the wiring so there is room for arranging transistors. In other words, there is room in the silicon area since the element count is small.

Therefore, there is the advantage of being able to effectively utilize the excess area.

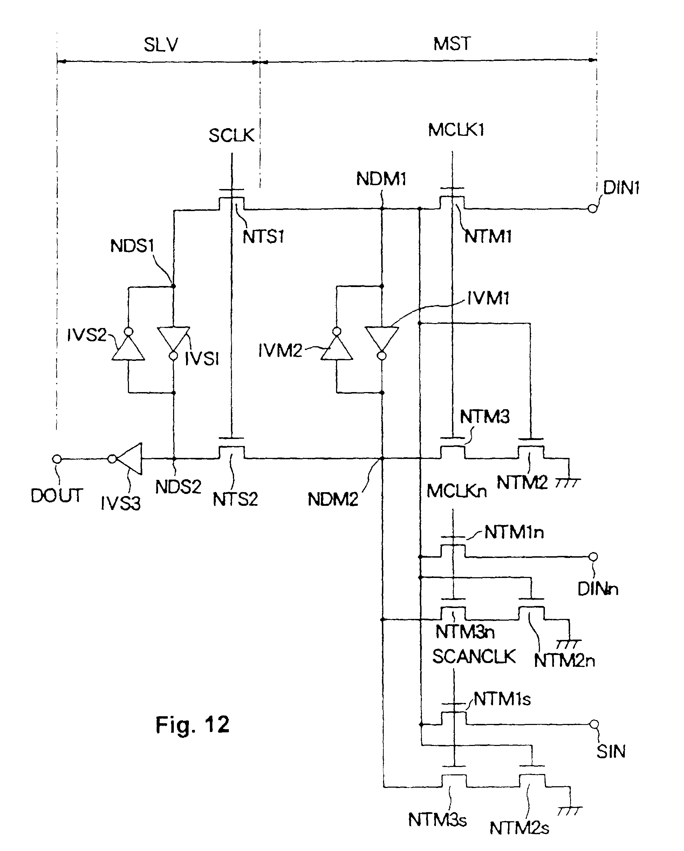

When compared with the complete CMOS type shown in Figure 12, it is possible to prevent an increase in the circuit scale of the clock driver and increase in the layout area due to the routing of the clock line by making the number of clocks one with respect to 1 data-in.

Also, the basic operation of said circuit maintains operation at low voltage by operating with the ratio circuit by loading low level "0" in node NDM1 when loading low level "0," loading low level "0" in node NDM2 with transfer gate NTM2 during the operation of loading high level "1," and changing the route of the circuit which propagates low level "0" and high level "1."

Therefore, decreasing the operational speed under low voltage can be minimized even in small transistor dimension since it is a circuit configuration with an n-channel main body effective for high-speed operation.

Furthermore, in this circuit configuration, it is possible to prevent an increase in load capacity accompanying gate increase since stabilized operation is obtained without providing a gate for making node NDS1 or NDS2 into ground level on slave latch side SLV like transfer gate NTM2 on the master latch MST side thus it is possible to prevent a decrease in the operational speed.

Figures 2-7 show operational speed and power consumption when simulation is executed with various power voltages V_{DD} of 4.5 V, 2.7 V, 1.7 V, and 1.5 V using the conventional complete CMOS type shift register and the shift register with the constitution in Figure 1, and in Figures 2-4, (a) shows the result of the complete CMOS type.

As the temperature for executing the simulation, it was suitably selected from 85°C, 25°C, and -25°C.

Also, the meaning of each code indicated with "N," "W," "P," "S," and "N" in each figure is that "N" is the n-channel, "W" is Weak, "P" is the p-channel, "S" is Strong, and "N" is Nominal (center).

For example, "NWPS" indicates a case when n-channel is weak and p-channel is strong and this simulation was executed in 5 types of combinations.

Figure 2 shows the operational speed on the master latch side in a case when the simulation was executed at power voltage V_{DD} = 2.7 V.

As it is evident from Figure 2, said invention's product can be operated at a speed more or less equal to the conventional complete CMOS type.

Figure 3 shows the operational speed on the slave latch side in a case when simulation is executed similarly at power voltage V_{DD} = 2.7 V.

As it is evident from Figure 3, said invention's product can be operated at a speed more or less equal to the conventional complete CMOS type even at the slave side.

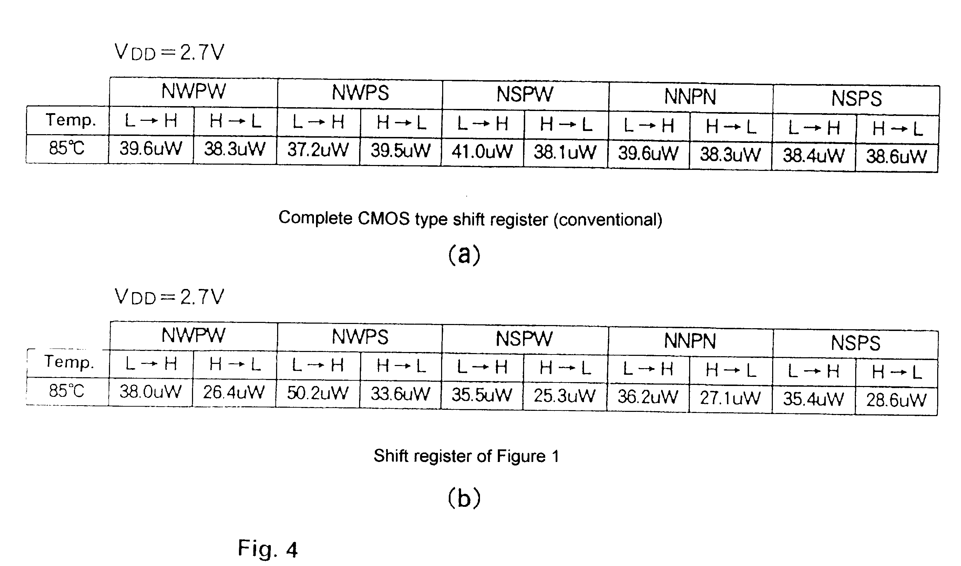

Figure 4 shows the power consumption within a given transmission time when simulation is similarly executed at power voltage V_{DD} = 2.7 V.

As it is evident from Figure 4, said invention's product consumes power more or less equal to or less than the conventional complete CMOS type.

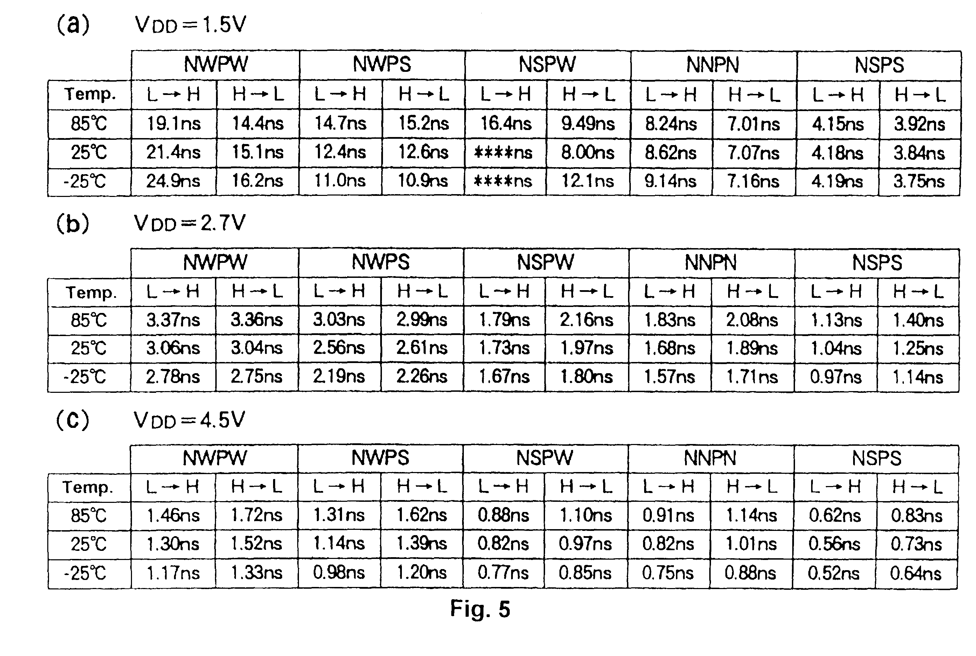

Also, Figure 5 shows the operational speed on the master latch side of said invention's product when simulation is executed by changing power voltage VDD to 1.5 V, 2.7 V, and 4.5 V at temperatures 85°C, 25°C, and -25°C.

In Figure 5(a), "*" is added to the 25°C and -25°C part in "NSPW" but this indicates that it did not operate at temperatures 25°C and -25°C in power voltage V_{DD} = 1.5 V.

However, it was verified that it operates at favorable speed when power voltage V_{DD} is raised from 1.5 V to 1.7 V.

As is evident from Figures 5(a) and (b), the master side of said invention's product operates at favorable speed even at low operational voltage.

Also, as is evident from Figure 5(c), the master side of said invention's product operates at favorable speed of. less than 2 nsec even at normal operational voltage.

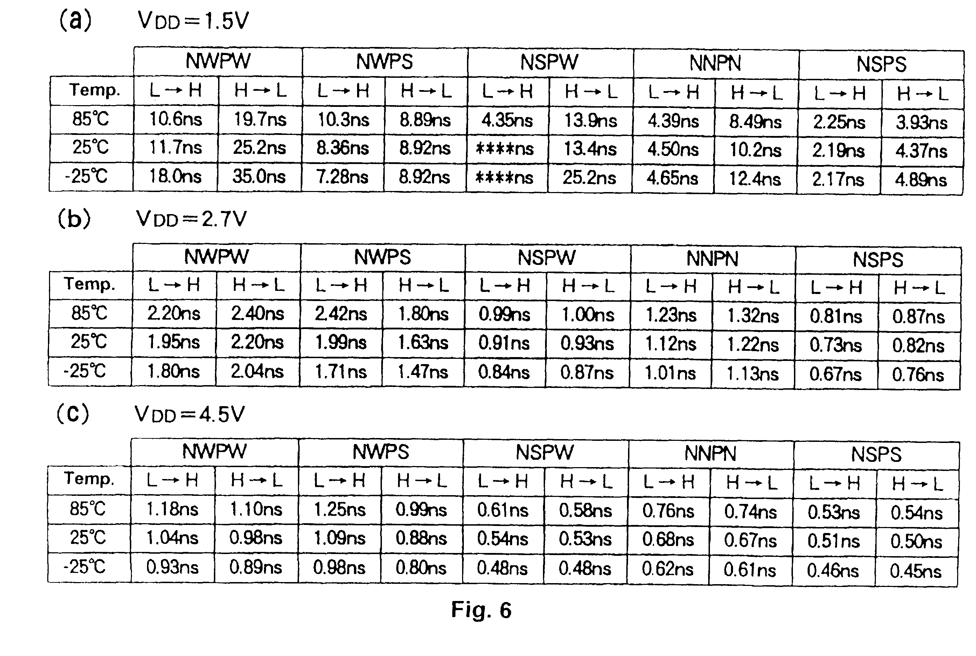

Figure 6 shows the operational speed on the slave latch side of said invention's product when simulation is executed by changing power voltage V_{DD} to 1.5 V, 2.7 V, and 4.5 V at temperatures 85°C, 25°C, and -25°C.

As is evident from Figures 6(a) and (b), even the slave side of said invention's product operates at favorable speed even at low operational voltage.

As is evident from Figure 6(c), even the slave side of said invention's product operates at favorable speed of below 2 nsec even at normal operational voltage.

Furthermore, Figure 7 shows the power consumption of said invention's product when simulation is executed by changing power voltage V_{DD} to 1.5 V, 2.7 V, and 4.5 V at temperatures 85°C, 25°C, and -25°C.

In this case, the operational speed becomes slow when power voltage V_{DD} becomes low so the simulation was executed by changing the machine cycle according to the size of power voltage V_{DD}.

As is evident from Figure 7, said invention's product can obtain a favorable power consumption value.

In said simulations, power voltage V_{DD} = 1.7 V was the operational threshold value. Of course, there is a decrease in the operational frequency in this area but the function as a shift register is provided sufficiently.

Also, even when compared with the case of conventional n-channel 1 transistor shown in Figure 15 at about 3 V, said invention's product of 3 transistors operates at a higher speed and can be considered a circuit which has a sufficient operational margin on the low voltage side.

Also, there is the possibility for improvement in the operational frequency through optimization of the transistor size and change in the constant for the ratio circuit, and can decrease the operable voltage if threshold value voltage V_{thN} of the n-channel transistor is decreased further.

### Application Example 2

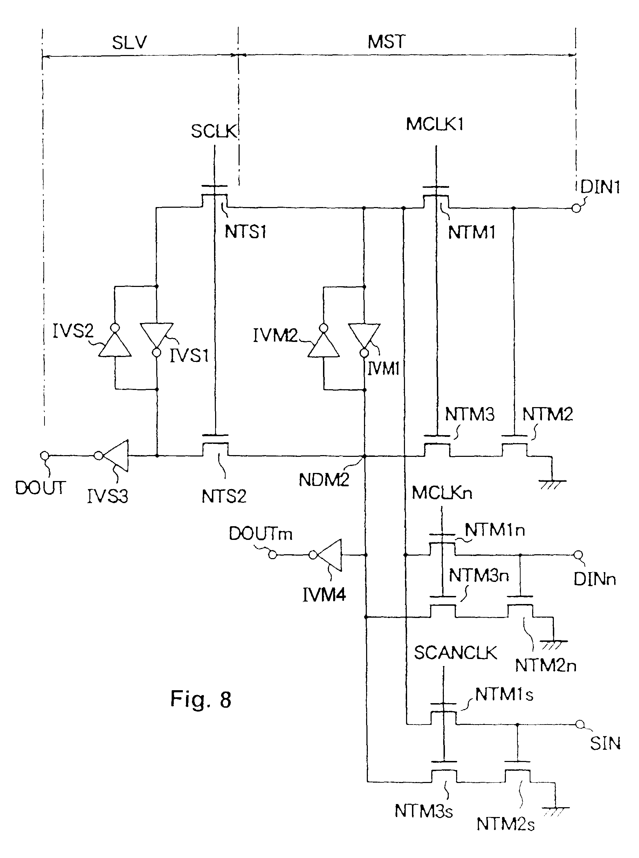

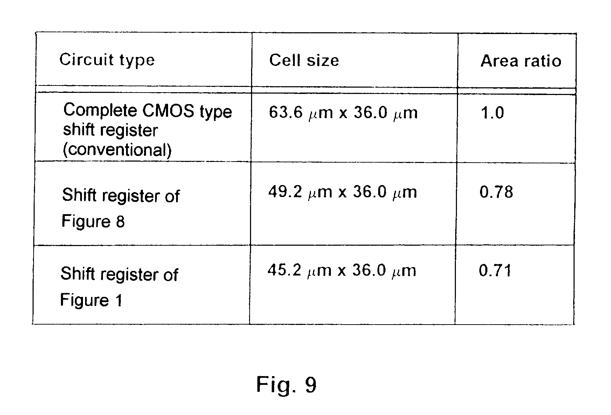

Figure 8 is a circuit diagram showing the second application example of a shift register related to said invention.

The point which differs in the second application example from said first application example is that latch data can be output at master latch MST whereas in the first application example, it was constituted to obtain output only from slave latch SLV.

Therefore, it is constituted to connect the input terminal of inverter IVM4 for data output to node NDM2 of master latch MST, and to connect the output terminal of inverter IVM4 to data output terminal DOUTm.

The rest of the constitution is the same as the first application example.

Even in this type of constitution, the same results as those in said first application example can be obtained.

Figure 9 shows the comparison result of the area ratio and the cell size when constituted as data-in DIN 4 and scan-in SIN 1 in the shift register of Figure 1 which does not have master output, shift register of Figure 8 which has master output, and conventional complete CMOS type shift register.

As is evident from Figure 9, the shift register according to this application example only needs 78% of the area of the complete CMOS type even when it has master output if complete CMOS type is "1" and only 71% of the area is needed in the shift register of Figure 1 which does not have master output thus said invention's product prevents an increase in the layout area.

Even in regard to the shift registar with the constitution in Figure 8, similar simulation as that which was executed using Figures 2-7 was executed but even in this case, more or less the same favorable results as the case of the first application example were obtained.

### Application Example 3

Figure 10 is a circuit diagram showing the third application example of said invention.

The point which differs in the third application example from said first application example is that whereas the first application example has a constitution of having connectad the input terminal of transfer gate NTS2 to node NDM2 connected with output terminal of inverter IVM1 and input terminal of IVM2 in master latch MST, in the third application example, the input terminal of transfer gate NTS2 in slave latch SLV is connected to node NDM1 of master latch MST through inverter IVS4.

Namely, this circuit differs from the circuit in the first application example in the point of having constituted to input the signals appearing in node NDM1 maintained stably at high level or low level as noted above into slave latch SLV, and input signals level inverted in inverter IVS4 into the input terminal of transfer gate NTS2.

Even in this type of constitution, the same results as those in said first application example can be obtained.

### Application Example 4

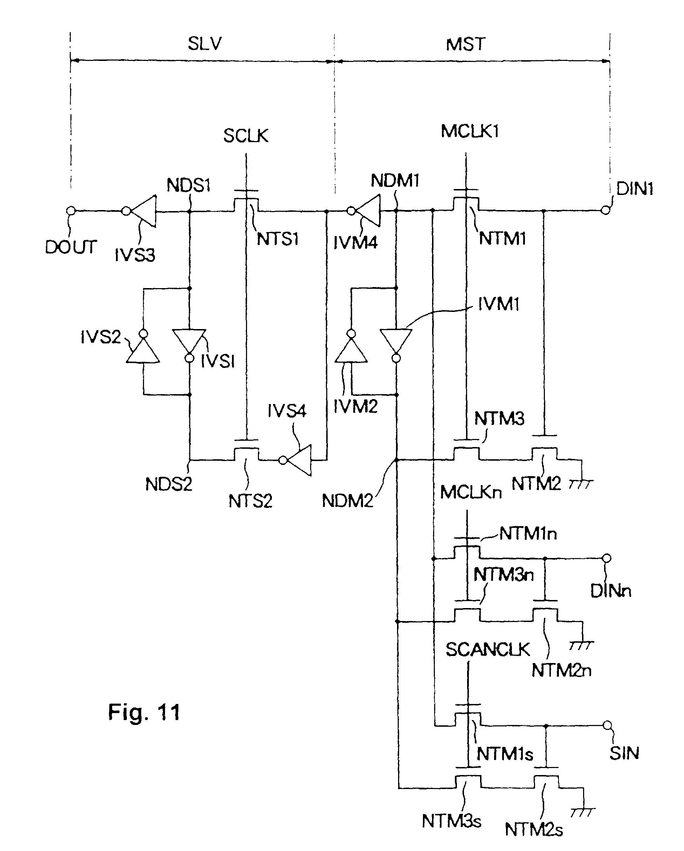

Figure 11 is a circuit diagram showing the fourth application example of a shift register related to said invention.

The point which the fourth application example differs from said third application example is having inserted inverter IVM4 between node NDM1 of master latch MST and the connection point of the input terminal of inverter IVS4 and the input terminal of transfer gate NTS1 of slave latch SLV.

As a result, it is constituted for data output terminal DOUT and inverter IVS3 which becomes the output step to be connected to node NDS1 connected to the output terminal of transfer gate NTS1 instead of node NDS2 connected to the output terminal of transfer gate NTS2 since the input signal level to slave latch SLV inverts from the case of said third application example.

The rest of the constitution is the same as the third application example.

Even in this type of constitution the same results as those in said first application example can be obtained.

### Application Example 5

Figure 12 is a circuit diagram showing the fifth application example of a shift register related to said invention.

The point which differs in the fifth application example from said first application example is that whereas the first application example was constituted to connect the gate terminals of transfer gates NTM2, NTM2n and NTM2s respectively to data input terminals DIN1, DINn, and SIN, the gates of each transfer gate NTM2, NTM2n and NTM2s are connected respectively to the output terminals of transfer gates NTM1, NTM1n, and NTM1s.

Namely, this circuit differs from the circuit in the first application example in that it was constituted to make node NDM2 into the ground level and for each transfer gate NTM2, NTM2n, NTM2s, NTM3, NTM3n, and NTM3s to take on the ON state when high-level signals are input into input terminals DIN1, DINn, and SIN, and clock signals MCLK1 and MCLKn and scan clock signal SCANCLK are input into the gates of transfer gates NTM1, NTM1n, and NTM1s and transfer gates NTM3, NTM3n, and NTM3s.

Even in this type of constitution, the same results as those in said first application example can be obtained.

### Application Example 6

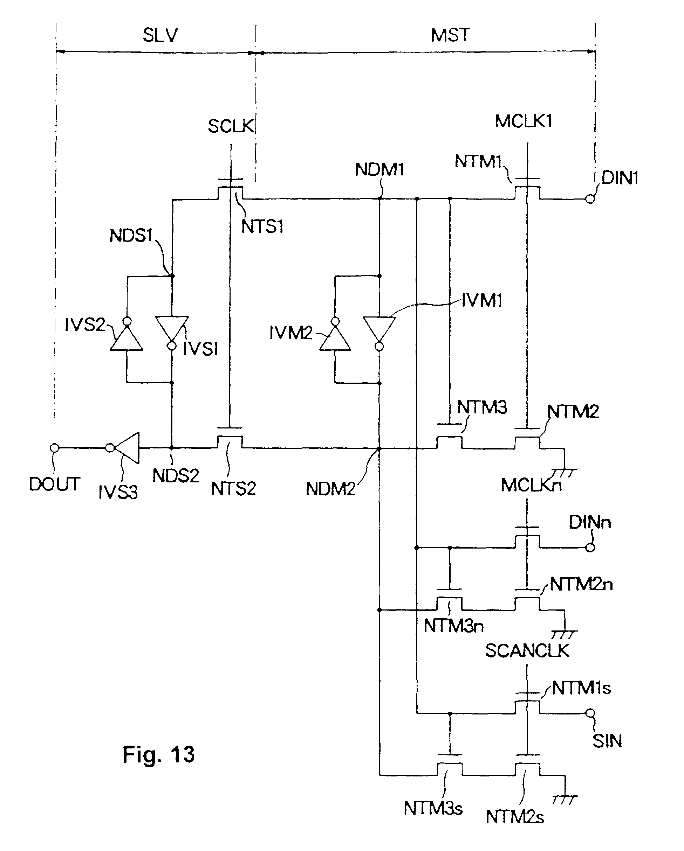

Figure 13 is a circuit diagram showing the sixth application example of a shift register related to said invention.

The point which differs in the sixth application example from said fifth application example is that whereas the fifth application example is constituted to connect the gate terminals of transfer gates NTM1, NTM1n and NTM1s and transfer gates NTM3, NTM3n, and NTM3s to the input line of clock signals MCLK1 and MCLKn and scan clock signal SCANCLK, and to connect the gate terminals of transfer gates NTM2, NTM2n, and NTM2s to the output terminals of transfer gates NTM1, NTM1n, and NTM1s, it was constituted to connect the gates of transfer gates NTM1, NTM1n and NTM1s and transfer gates NTM2, NTM2n, and NTM2s respectively to the input lines of clock signals MCLK1 and MCLKn and scan clock signal SCANCLK, and to connect the gate terminals of transfer gates NTM3, NTM3n, and NTM3s respectively to the output terminals of transfer gates NTM1, NTM1n, and NTM1s.

The rest of the constitution is the same as the fifth application example.

Even in this type of constitution, the same results as those in said first application example can be obtained.

### Application Example 7

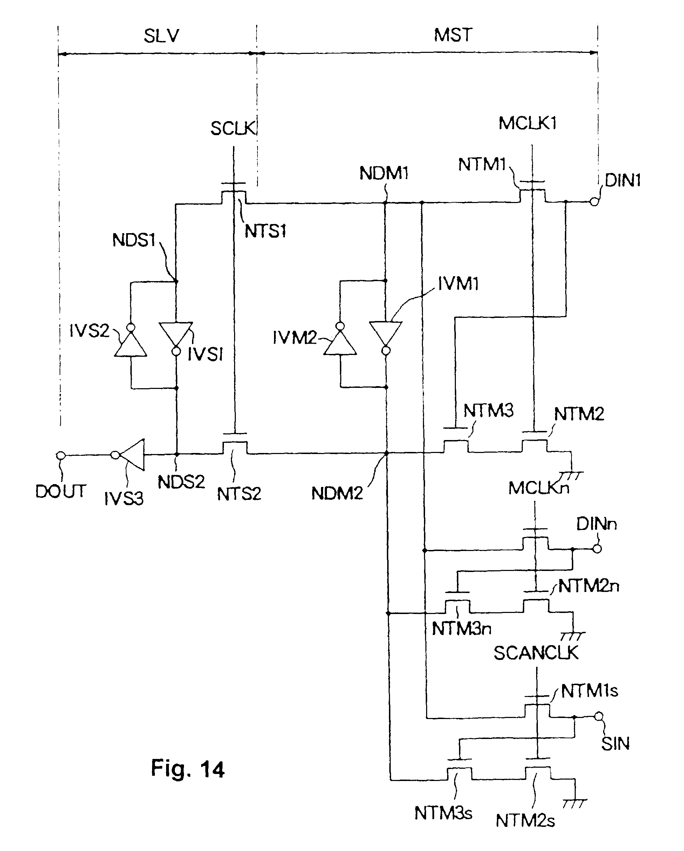

Figure 14 is a circuit diagram showing the seventh application example of a shift register related to said invention.

The point which differs in the seventh application example from said sixth application example is that the gate terminals of transfer gates NTM3, NTM3n, and NTM3s are respectively connected to data input terminals DIN1, DINn, and SIN instead of the output terminals of transfer gates NTM1, NTM1n, and NTM1s.

The rest of the constitution is the same as the sixth application example.

Even in this type of constitution, the same results as those in said first application example can be obtained.
[0068]

In the first application example shown in Figure 1, transfer gates NTM1 and NTM3 can be constituted of p-channel MOS transistors. In this case, it is necessary to logically invert clock signals MCLK1 in the operation. Also, it is the same regarding transfer gates NTS1 and NTS2.

## Claims

1. A shift register for operation at a low supply voltage, comprising:
a master stage (MST) with a first inverter (IVM1) and a second inverter (IVM2) connected in a cross-coupled manner; and a slave stage (SLV) with a third inverter (IVS1) and a fourth inverter (IVS2) connected in a cross-coupled manner;
input circuitry (NTM1, NTM2, NTM3) for coupling an input signal on a data input terminal (DIN1) to an input of the first inverter (IVM1) of the master stage and for coupling a second signal to an input of the second inverter (IVM2) in response to a first clock signal (MCLK1);
coupling circuitry (NTS1, NTS2) for coupling an output of the master stage to an input of the slave stage in response to a second clock signal (SCLK); and
a data output terminal (DOUT) connected to an output of the slave stage; characterised in that:
the input circuitry includes a first transfer gate (NTM1) connected between the data input terminal and the input of the first inverter;
and a second transfer gate (NTM2) and a third transfer gate (NTM3) connected in series between the input of the second inverter (IVM2) and a reference voltage terminal, such that the input of the second inverter is connected to the reference voltage terminal in response to the first clock signal (MCLK1) and the input signal on the data input terminal; and
the coupling circuitry includes a fourth transfer gate (NTS1) connected between an output of the second inverter (IVM2) and an input of the third inverter (IVS1); and a fifth transfer gate (NTS2) connected between an output of the first inverter (IVM1) and an input of the fourth inverter (IVS2).

2. A shift register according to claim 1, characterised in that: the third transfer gate (NTM3) is connected in series between the second transfer gate (NTM2) and the input of the second inverter (IVM2); and a gate terminal of the first transfer gate (NTM1) is connected to the first clock signal (MCLK1).

3. A shift register according to claim 2, characterised in that a gate terminal of the third transfer gate (NTM3) is connected to the first clock signal (MCLK1); and a gate terminal of the second transfer gate (NTM2) is connected to the data input terminal (DIN1).

4. A shift register according to claim 2, characterised in that a gate terminal of the second transfer gate (NTM2) is connected to the first clock signal (MCLK1); and a gate terminal of the third transfer gate (NTM3) is connected to the data input terminal (DIN1).

5. A shift register according to claim 2, characterised in that a gate terminal of the third transfer gate (NTM3) is connected to the first clock signal (MCLK1); and a gate terminal of the second transfer gate (NTM2) is connected to the input (NDM1) of the first inverter (IVM1).

6. A shift register according to any preceding claim, characterised in that an output of a fifth inverter (IVS4) is connected to the fifth transfer gate (NTS2) in place of the output of the first inverter; and an input of the fifth inverter (IVS4) is connected to the output (NDM1) of the second inverter (IVM2).

7. A shift register according to any preceding claim, characterised in that a sixth inverter (IVM4) has an output connected to a second data output terminal (DOUTm) and has an input connected to an output (NDM2) of the first inverter (IVM1) or to an output of the second inverter (IVM2).

## Patentansprüche

1. Schieberegister, das bei einer niedrigen Versorgungsspannung betrieben werden kann, mit
einer Hauptstufe (MST) mit einem ersten Inverter (IVM1) und einem zweiten Inverter (IVM2), die antiparallel miteinander verbunden sind; und einer Nebenstufe (SLV) mit einem dritten Inverter (IVS1) und einem vierten Inverter (IVS2), die antiparallel miteinander verbunden sind;
einer Eingabeschaltungsanordnung (NTM1, NTM2, NTM3), die dazu dient, ein Eingangssginal an einem Dateneingangsanschluß (DIN1) an einen Eingang des ersten Inverters (IVM1) der Hauptstufe zu koppeln und ein zweites Signal an einen Eingang des zweiten Inverters (IVM2) in Abhängigkeit von einem ersten Taktsignal (MCLK1) zu koppeln;
einer Kopplungsschaltungsanordnung (NTS1, NTS2), die dazu dient, einen Ausgang der Hauptstufe an einen Eingang der Nebenstufe in Abhängigkeit von einem zweiten Taktsignal (SCLK) zu koppeln; und
einem Datenausgangsanschluß (DOUT), der mit einem Ausgang der Nebenstufe verbunden ist; dadurch gekennzeichnet, daß
die Eingangsschaltungsanordnung ein erstes Transfergate (NTM1), das zwischen den Dateneingangsanschluß und den Eingang des ersten Inverters geschaltet ist,
ein zweites Transfergate (NTM2) und ein drittes Transfergate (NTM3) umfaßt, die in Reihe zwischen den Eingang des zweiten Inverters (IVM2) und einen Referenzspannungsanschluß geschaltet sind, so daß der Eingang des zweiten Inverters mit dem Referenzspannungsanschluß in Abhängigkeit von dem ersten Taktsignal (MCLK1) und dem Eingangssignal an dem Dateneingangsanschluß verbunden wird; und
die Kopplungsschaltungsanordnung ein viertes Tranfergate (NTS1), das zwischen einen Ausgang des zweiten Inverters (IVM2) und einen Eingang des dritten Inverters (IVS1) geschaltet ist;
und ein fünftes Transfergate (NTS2) umfaßt, das zwischen einen Ausgang des ersten Inverters (IVM1) und einen Eingang des vierten Inverters (IVS2) geschaltet ist.

2. Schieberegister nach Anspruch 1, dadurch gekennzeichnet, daß das dritte Transfergate (NTM3) in Reihe zwischen das zweite Tranfergate (NTM2) und den Eingang des zweiten Inverters (IVM2) geschaltet ist; und ein Gateanschluß des ersten Transfergates (NTM1) mit dem ersten Taktsignal (MCLK1) verbunden ist.

3. Schieberegister nach Anspruch 2, dadurch gekennzeichnet, daß ein Gateanschluß des dritten Transfergates (NTM3) mit dem ersten Taktsignal (MCLK1) verbunden ist; und ein Gateanschluß des zweiten Transfergates (NTM2) mit dem Dateneingangsanschluß (DIN1) verbunden ist.

4. Schieberegister nach Anspruch 2, dadurch gekennzeichnet, daß ein Gateanschluß des zweiten Transfergates (NTM2) mit dem ersten Taktsignal (MCLK1) verbunden ist; und ein Gateanschluß des dritten Transfergates (NTM3) mit dem Dateneingangsanschluß (DIN1) verbunden ist.

5. Schieberegister nach Anspruch 2, dadurch gekennzeichnet, daß ein Gateanschluß des dritten Transfersgates (NTM3) mit dem ersten Taktsignal (MCLK1) verbunden ist; und ein Gateanschluß des zweiten Transfergates (NTM2) mit dem Eingang (NDM1) des ersten Inverters (IVM1) verbunden ist.

6. Schieberegister nach einem der vorhergehenden Ansplrüche, dadurch gekennzeichnet, daß an Stelle des Ausgangs des ersten Inverters ein Ausgang eines fünften Inverters (IVS4) mit dem fünften Transfergate (NTS2) verbunden ist; und ein Eingang des fünften Inverters (IVS4) mit dem Ausgang (NDM1) des zweiten Inverters (IVM2) verbunden ist.

7. Schieberegister nach einem der vorhergehenden Ansprüche, dadurch gekennzeichnet, daß ein Ausgang eines sechsten Inverters (IVM4) mit einem zweiten Datenausgangsanschluß (DOUTm) verbunden ist und ein Eingang des sechsten Inverters (IVM4) mit einem Ausgang (NDM2) des ersten Inverters (IVM1) oder mit einem Ausgang des zweiten Inverters (IVM2) verbunden ist.

## Revendications

1. Registre à décalage destiné à fonctionner à une tension d'alimentation basse, comprenant :
un étage maître (MST) avec un premier inverseur (IVM1) et un deuxième inverseur (IVM2) connectés selon un couplage en croix ; et un étage esclave (SLV) avec un troisième inverseur (IVS1) et un quatrième inverseur (IVS2) connectés selon un couplage en croix ;
un circuit d'entrée (NTM1, NTM2, NTM3) pour le couplage d'un signal d'entrée sur une borne d'entrée de données (DIN1) avec une entrée du premier inverseur (IVM1) de l'étage maître et pour coupler un deuxième signal avec une entrée du deuxième inverseur (IVM2) en réponse à un premier signal d'horloge (MCLK1) ;
un circuit de couplage (NTS1, NTS2) pour le couplage d'une sortie de l'étage maître à une entrée de l'étage esclave en réponse à un deuxième signal d'horloge (MCLK) ; et
une borne de sortie de données (DOUT) connectée à une sortie de l'étage esclave ; caractérisé en que ce :
le circuit d'entrée comporte une première porte de transfert (NTM1) connectée entre la borne d'entrée de données et l'entrée du premier inverseur;
et une deuxième porte de transfert (NTM2) et une troisième porte de transfert (NTM3) connectées en série entre l'entrée du deuxième inverseur (IVM2) et une borne de tension de référence, de sorte que l'entrée du deuxième inverseur est connectée à la borne de tension de référence en réponse au premier signal d'horloge (MCLK1) et au signal d'entrée sur la borne d'entrée de données ; et
le circuit de couplage comporte une quatrième porte de transfert (NTS1) connectée entre une sortie du deuxième inverseur (IVM2) et une entrée du troisième inverseur (IVS1); et une cinquième porte de transfert (NTS2) connectée entre une sortie du premier inverseur (IVM1) et une entrée du quatrième inverseur (IVS2).

2. Registre à décalage selon la revendication 1, caractérisé en ce que : la troisième porte de transfert (NTM3) est connectée en série entre la deuxième porte de transfert (NTM2) et l'entrée du deuxième inverseur (IVM2) ; et une borne de porte de la première porte de transfert (NTM1) est connectée au premier signal d'horloge (MCLK1).

3. Registre à décalage selon la revendication 2, caractérisé en ce qu'une borne de porte de la troisième porte de transfert (NTM3) est connectée au premier signal d'horloge (MCLK1) ; et une borne de porte de la deuxième porte de transfert (NTM2) est connectée à la borne d'entrée de données (DIN1).

4. Registre à décalage selon la revendication 2, caractérisé en ce qu'une borne de porte de la deuxième porte de transfert (NTM2) est connectée au premier signal d'horloge (MCLK1) ; et une borne de porte de la troisième porte de transfert (NTM3) est connectée à la borne d'entrée de donnée (DIN1).

5. Registre à décalage selon la revendication 2, caractérisé en ce qu'une borne de porte de la troisième porte de transfert (NTM3) est connectée au premier signal d'horloge (MCLK1) ; et une borne de porte de la deuxième porte de transfert (NTM2) est connectée à l'entrée (NDM1) du premier inverseur (IVM1).

6. Registre à décalage selon l'une quelconque des revendications précédentes, caractérisé en ce qu'une sortie d'un cinquième inverseur (IVS4) est connectée à la cinquième porte de transfert (NTS2) à la place de la sortie du premier inverseur ; et une entrée du cinquième inverseur (IVS4) est connectée à la sortie (NDM1) du deuxième inverseur (IVM2).

7. Registre à décalage selon l'une quelconque des revendications précédentes, caractérisé en ce qu'un sixième inverseur (IVM4) comporte une sortie connectée à une deuxième borne de sortie de données (DOUTm) et comporte une entrée connectée à une sortie (NDM2) du premier inverseur (IVM1) ou à une sortie du deuxième inverseur (IVM2).
